# EUROPÄISCHE PATENTSCHRIFT

(11) **EP 1 959 005 B1**
(45) Veröffentlichungstag und Bekanntmachung des Hinweises auf die Patenterteilung: **22.12.2010**
(21) Anmeldenummer: 07019884.1
(22) Anmeldetag: 11.10.2007
(51) Int. Cl.: C11D 3/37

(54) **Reinigungsmittel zum Reinigen von Gegenständen**
Cleaning agent for cleaning objects
Dispositif de nettoyage destiné au nettoyage d'objets

(30) Priorität: 18.10.2006 DE 202006015967 U
(43) Veröffentlichungstag der Anmeldung: 20.08.2008
(73) Patentinhaber: kolb Cleaning Technology GmbH, 47877 Willich (DE)
(72) Erfinder: Pollmann, Georg, 47877 Willich (DE); Linker, Christian, 42549 Velbert (DE)
(74) Vertreter: von Kreisler Selting Werner

(56) Entgegenhaltungen:
- EP-A- 1 837 182
- WO-A-97/38076
- US-A- 5 368 779
- US-A- 5 977 050
- US-A- 6 043 209
- US-A1- 2004 204 332

## Beschreibung

Die Erfindung betrifft **die Verwendung** eines Reinigungsmittels zum Reinigen von Siebschablonen und von mit elektronischen Bauteilen bestückten Leiterplatten, Lötrahmen, Karrier, Magazine **und** Maschinenteile von Löt- oder Handlingsmaschinen, die bei der Herstellung elektronischer Bauteile bzw. Komponenten eingesetzt werden. Die zu reinigenden Gegenstände sind im Wesentlichen flächig ausgebildet; sie können aber auch gekrümmt ausgebildet und, beispielsweise im Falle einer Leiterplatte, vorstehende elektronische Bauteile aufweisen.

US 5,368,779 beschreibt ein Waschmittel und entsprechende Formulierungen zur Reinigung von Gegenständen, die mit Öl, Schmutz, Schwermetall, Straßenabrieb oder ähnlichem verunreinigt sind durch Separieren der Materialien vom Abwasser.

WO 97/38076 beschreibt eine wässrige Glasreinigungszusammensetzung mit einer optimierten Haftung an vertikalen Glasflächen.

US 5,977,050 beschreibt eine sprühbare Reinigungsgelzusammensetzung.

US 6,043,209 beschreibt eine Reinigungszusammensetzung zum Reinigen von Geweben und Teppichen.

US 2004/0204332 A1 beschreibt ein Reinigungstuch aus einem Vlies, das mit einer Reinigungszusammensetzung imprägniert ist.

EP 1 837 182 A1 beschreibt ein Reinigungsverfahren für einen Tintenstrahldrucker sowie eine Reinigungszusammensetzung zur Entfernung von Inkjetfarben.

Im Rahmen der Herstellung beispielsweise von Siebschablonen und von mit elektronischen Bauteilen bestückten Leiterplatten findet u.a. auch ein Reinigungsschritt statt. Die zu reinigenden Gegenstände werden mit einem Reinigungsmittel, ggf. auch in verdünnter Form, besprüht. Hierdurch werden die Schmutzpartikel gelöst. Würde das verschmutzte Reinigungsmittel in einem Sammelbehälter gesammelt, findet eine Entmischung statt, d.h. es kommt zu einer deutlichen Trennung in unterschiedliche Phasen, bei der sich u.a. die Schmutzpartikel im Ruhezustand absetzen. Um ein Abfiltrieren der Schmutzpartikel in Anlagen mit einem Sammelbehälter durchführen zu können, müsste in dem Sammelbehälter ein Mischwerkzeug vorgesehen sein, um die entmischten Phasen für ein Filtern wieder zu Vermischen. Abgesehen davon, dass entsprechende Mischwerkzeuge mit zusätzlichen Kosten verbunden sind, ist die Nachrüstung in bereits bestehenden Anlagen auch nur bedingt möglich.

Aufgabe der Erfindung ist es, die vorgenannten Nachteile zu vermeiden und ein Reinigungsmittel **einzusetzen,** das nach dem Ablösen der Schmutzpartikel wieder leichter filtrierbar und insoweit regenerierbar ist.

Diese Aufgabe wird gelöst **durch die Verwendung eines** Reinigungsmittels, **das** zumindest wasserlöslichen Glykolether, insbesondere Alkylglykolether, und Dispergiermittel beinhaltet. Durch das erfindungsgemäß **eingesetzte** Reinigungsmittel ist ein bereites Reinigungsspektrum sowie eine einfache Filtration gewährleistet. Die Moleküle des Reinigungsmittels legen sich nach der Ablösung der Schmutzpartikel direkt um die Schmutzpartikel herum und erzeugen somit eine homogene Kapselung.

Das erfindungsgemäß **eingesetzte** Gemisch bewirkt eine Dispergierung der abzureinigenden Schmutzpartikel, wie sie üblicherweise in der Elektronik vorkommen, wie z. B. Lötpaste, Kolophonium, SMD-Kleber, etc.. Damit sind alle Schmutzpartikel komplett deaktiviert und können sich auch nicht mehr an anderen Stellen beispielsweise am zu reinigenden Gegenstand oder an anderen Anlageteilen absetzen. Die Schmutzpartikel bleiben durch das Dispergiermittel in der Lösung fein verteilt und fallen nicht aus bzw. setzen sich auch nicht als sichtbarer Schlamm an der Oberfläche oder am Boden des Reinigungsbades ab.

Hierdurch kann nach dem Reinigungsvorgang das verschmutze Reinigungsmittel problemlos gefiltert werden, ohne dass das Reinigungsbad vorher nochmals aufbereitet werden muss. Die Kettenlänge der Moleküle des Dispergiermittels ist dabei von seiner Kettenlänge so kein zu wählen, dass dieses nicht filtrierbar ist und damit nur die Schmutzpartikel mit der größeren Kettenlänge im Filter verweilen. Anschließend kann das Reinigungsmittel dem Reinigungskreislauf wieder zugeführt werden, wodurch der Verbrauch an Reinigungsmittel minimiert wird.

Das Reinigungsmittel kann als Alkylglykolether zumindest Tripropylenglykolmonoether beinhalten.

Das Reinigungsmittel kann als Alkylglykolether zumindest Dipropylenglykolmonomethylether beinhalten.

Das Reinigungsmittel kann als Dispergiermittel zumindest Natriumpolyacrylsäuresalz beinhalten.

Das Reinigungsmittel kann als Dispergiermittel zumindest Maleinsäure/Olefin-Copolymerisat-Natrium-Salz beinhalten.

Vorzugsweise ist das Gewichtsverhältnis von wasserlöslichem Glykolether und Dispergiermittel in etwa 90:100, vorzugsweise 96:4.

Das Gemisch aus wasserlöslichem Glykolether und Dispergiermittel kann in einem Volumenverhältnis von 1:3 - 1:5 mit Wasser verdünnt sein. Eine solche Verdünnung wird vor der Anwendung des Reinigungsmittels durchgeführt und kann entweder bereits im Rahmen der Herstellung oder aber erst kurz vor der Anwendung, d.h. vor Ort durchgeführt werden.

Der Wasseranteil liegt damit zwischen 75 und 85 Volumenprozent.

Im Folgenden wird ein in den Zeichnungen dargestelltes Ausführungsbeispiel der Erfindung erläutert. Es zeigen:

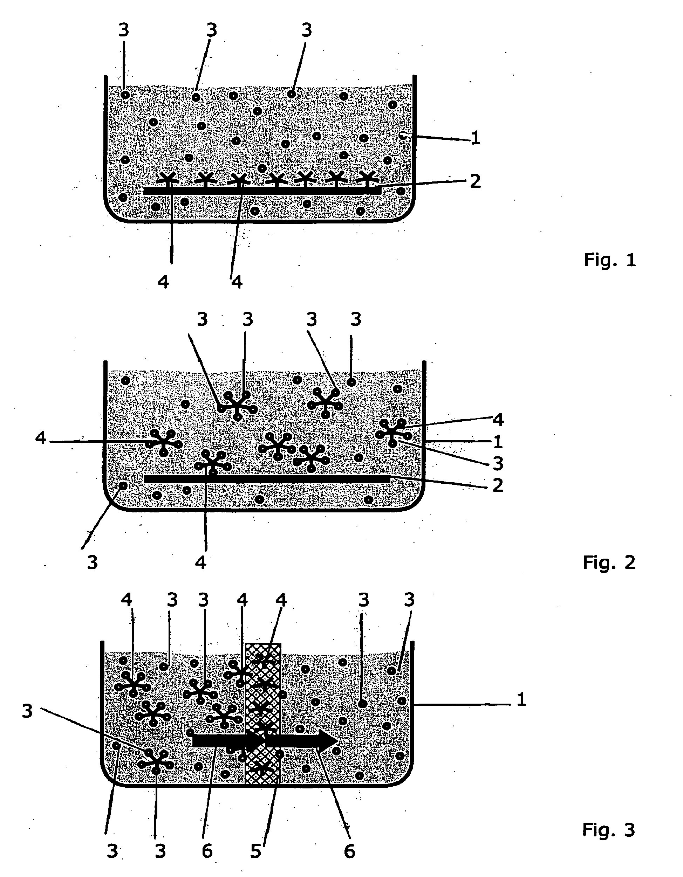

Fig. 1 bis 3 unterschiedliche Verfahrensstadien.

In allem Figuren werden für gleiche bzw. gleichartige Bauteile übereinstimmende Bezugszeichen verwendet.

In den Figuren ist ein Reinigungsbehälter 1 dargestellt, in dem ein zu reinigender Gegenstand 2 angeordnet ist. Der Reinigungsbehälter 1 ist gefüllt mit einem erfindungsgemäßen Reinigungsmittel 3, das mit Wasser verdünnt ist.

Auf dem zu reinigenden Gegenstand 2 sind auf einer Seite Schmutzpartikel 4 skizzenhaft dargestellt. Die Moleküle des Reinigungsmittels 3 sind als Kreise dargestellt.

Wie insbesondere Fig. 1 und 2 zu entnehmen ist, unterwandern die Moleküle des Reinigungsmittels 3 die Adhäsion der an dem Gegenstand 2 anhaftenden Schmutzpartikel 4 und entfernen so die Schmutzpartikel 4 vom Gegenstand 2. Die Moleküle des Reinigungsmittels 3 legen sich dabei nach deren Ablösung direkt um die Schmutzpartikel 4 herum und bewirken so eine homogene Kapselung.

Damit sind alle Schmutzpartikel 4 komplett deaktiviert und können sich nicht mehr an anderen Stellen beispielsweise erneut am Gegenstand 2 oder am Reinigungsbehälter 1 absetzen.

Wie aus Fig. 3 ersichtlich, werden die von den Molekülen des Reinigungsmittels 3 umschlossenen Schmutzpartikel 4, die im Gesamtmedium verteilt vermischt sind, in einem Filter 5 gefiltert. Da die Moleküle des Dispergiermittels eine kürzere Kettenlänge als die Moleküle der Schmutzpartikel 4 haben, werden die Schmutzpartikel 4 ausgefiltert und damit zurückgehalten, während die Moleküle des Reinigungsmittels 3 den Filter 5 in Richtung der Pfeile 6 passieren. Auf diese Weise wird das Reinigungsmittel 3 regeneriert und steht erneut zur Verfügung.

Die Schmutzpartikel 4 bleiben durch das im erfindungsgemäß eingesetzten Reinigungsmittel 3 befindliche Dispergiermittel in der Lösung fein verteilt. Sie fallen daher nicht aus und setzen sich nicht ab, so dass - im Gegensatz zur Verwendung bekannter Reinigungsmittel - keine vorherige Vermischung vor der Filtration erforderlich ist.

## Patentansprüche

1. **Verwendung eines** Reinigungsmittels (3) zum Reinigen von Siebschablonen, von mit elektronischen Bauteilen bestückten Leiterplatten, Lötrahmen, Karriern, Magazinen und Maschinenteilen von Löt- und Handlingsmaschinen, **wobei** das Reinigungsmittel (3) zumindest wasserlöslichen Glykolether, insbesondere Alkylglykolether und Dispergiermittel beinhaltet.

2. Verwendung eines Reinigungsmittel**s** (3) nach dem vorhergehenden Anspruch, **dadurch gekennzeichnet, dass** der Alkylglykolether zumindest Tripropylenglykolmonomethylether beinhaltet.

3. Verwendung eines Reinigungsmittel**s** (3) nach einem der vorhergehenden Ansprüche, **dadurch gekennzeichnet, dass** der Alkylglykolether zumindest Dipropylenglykolmonomethylether beinhaltet.

4. Verwendung eines Reinigungsmittel**s** (3) nach einem der vorhergehenden Ansprüche, **dadurch gekennzeichnet, dass** das Dispergiermittel zumindest Natriumpolyacrylsäuresalz beinhaltet.

5. Verwendung eines Reinigungsmittel**s** (3) nach einem der vorhergehenden Ansprüche, **dadurch gekennzeichnet, dass** das Dispergiermittel zumindest Maleinsäure/Olefin-Copolymerisat-Natrium-Salz beinhaltet.

6. Verwendung eines Reinigungsmittels (3) nach einem der vorhergehenden Ansprüche, **dadurch gekennzeichnet, dass** das Gewichtsverhältnis von wasserlöslichem Glykolether und Dispergiermittel 90:10, insbesondere 96:4 ist.

7. Verwendung eines Reinigungsmittels (3) nach einem der vorhergehenden Ansprüche, **dadurch gekennzeichnet, dass** das Volumenverhältnis von Glykolether und Dispergiermittel zu Wasser 1:3 - 1:5 beträgt.

## Claims

1. Use of a detergent (3) for cleaning silk screen stencils, printed circuit boards provided with electronic components, soldering frames, carriers, magazines and machine parts of soldering and handling machines, wherein said detergent (3) comprises at least water-soluble glycol ether, especially alkyl glycol ether, and dispersant.

2. Use of a detergent (3) according to the preceding claim, **characterized in that** said alkyl glycol ether comprises at least tripropylene glycol monomethyl ether.

3. Use of a detergent (3) according to either of the preceding claims, **characterized in that** said alkyl glycol ether comprises at least dipropylene glycol monomethyl ether.

4. Use of a detergent (3) according to any of the preceding claims, **characterized in that** said dispersant comprises at least polyacrylic acid sodium salt.

5. Use of a detergent (3) according to any of the preceding claims, **characterized in that** said dispersant comprises at least maleic acid/olefin copolymer sodium salt.

6. Use of a detergent (3) according to any of the preceding claims, **characterized in that** the weight ratio of water-soluble glycol ether to dispersant is 90:10, especially 96:4.

7. Use of a detergent (3) according to any of the preceding claims, **characterized in that** the volume ratio of glycol ether and dispersant to water is from 1:3 to 1:5.

## Revendications

1. Utilisation d'un détergent (3) pour nettoyer des stencils de sérigraphie, des plaquettes de circuits imprimés équipées avec des composants électroniques, des cadres de soudage, des porte-cartes, des magasins et des pièces de machines provenant de machines de soudage et de machines de manipulation, ledit détergent (3) comprenant au moins un éther de glycol soluble dans l'eau, notamment un éther alkylique de glycol, et un dispersant.

2. Utilisation d'un détergent (3) selon la revendication précédente, **caractérisée en ce que** ledit éther alkylique de glycol comprend au moins l'éther monométhylique de tripropylène glycol.

3. Utilisation d'un détergent (3) selon l'une quelconque des revendications précédentes, **caractérisée en ce que** ledit éther alkylique de glycol comprend au moins l'éther monométhylique de dipropylène glycol.

4. Utilisation d'un détergent (3) selon l'une quelconque des revendications précédentes, **caractérisée en ce que** ledit dispersant comprend au moins le sel de sodium de l'acide polyacrylique.

5. Utilisation d'un détergent (3) selon l'une quelconque des revendications précédentes, **caractérisée en ce que** ledit dispersant comprend au moins le sel de sodium d'un copolymère d'acide maléique et d'une oléfine.

6. Utilisation d'un détergent (3) selon l'une quelconque des revendications précédentes, **caractérisée en ce que** le rapport pondéral entre l'éther de glycol soluble dans l'eau et le dispersant est 90:10, notamment 96:4.

7. Utilisation d'un détergent (3) selon l'une quelconque des revendications précédentes, **caractérisée en ce que** le rapport volumique de l'éther de glycol et le dispersant à l'eau est de 1:3 à 1:5.
